**Europäisches Patentamt**

**European Patent Office**

**Office européen des brevets**

(19)

(11) Numéro de publication : **0 616 434 A1**

(12) # DEMANDE DE BREVET EUROPEEN

(21) Numéro de dépôt : **94400564.4**

(22) Date de dépôt : **15.03.94**

(51) Int. Cl.⁵ : **H04B 1/30,** H03D 3/00

(30) Priorité : **15.03.93 FR 9302948**

(43) Date de publication de la demande :
**21.09.94 Bulletin 94/38**

(84) Etats contractants désignés :
**AT BE CH DE DK ES FR GB IT LI NL SE**

(71) Demandeur : **ALCATEL RADIOTELEPHONE**
**10, rue de la Baume**
**F-75008 Paris (FR)**

(72) Inventeur : **Gourgue, Frederic**
**33, Rue Rennequin**
**F-75017 Paris (FR)**

(74) Mandataire : **Renaud-Goud, Thierry et al**
**c/o SOSPI,**
**14-16, rue de la Baume**
**F-75008 Paris (FR)**

(54) **Récepteur numérique à fréquence intermédiaire et procédé de filtrage en bande de base mis en oeuvre dans ce récepteur.**

(57)   Récepteur numérique comprenant des moyens d'antenne (11) pour capter des signaux, des moyens (21) pour convertir à une fréquence intermédiaire prédéterminée un signal entrant et des moyens de traitement en bande de base (14).

Ce récepteur comprend en outre des moyens de conversion analogique/numérique (15) avec suréchantillonnage par rapport à la largeur de bande du signal recevant en entrée le signal à fréquence intermédiaire, et des moyens de filtrage à décimation (9, 10) recevant en entrée le signal converti issu desdits moyens de conversion analogique/numérique (15) et reliés en sortie aux moyens de traitement en bande de base (14).

FIG.2

EP 0 616 434 A1

La présente invention concerne un récepteur numérique à fréquence intermédiaire.

Elle vise également un procédé de filtrage en bande de base mis en oeuvre dans ce récepteur.

Les récepteurs numériques actuels doivent extraire l'information sur des voies en phase et en quadrature après avoir ramené le signal en bande de base. Cela est généralement réalisé en utilisant deux mélangeurs recevant :

- d'une part, un signal d'entrée ;
- d'autre part, un signal en provenance d'un oscillateur local pour la voie en phase, et le même signal déphasé de π/2 pour la voie en quadrature.

Le signal en sortie de chaque mélangeur doit être filtré (de manière analogique) puis subir une conversion analogique/numérique et enfin un traitement en bande de base.

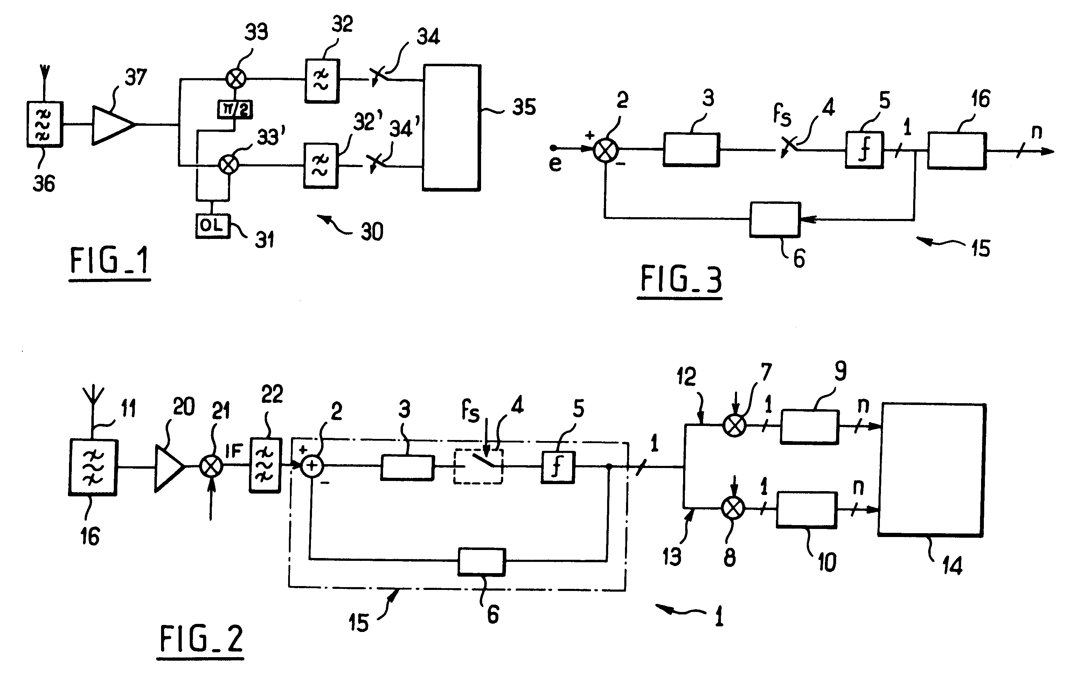

A titre d'exemple, en référence à la figure 1, un dispositif récepteur 30 comprend généralement en amont un premier filtre passe-bande 36, un amplificateur à faible bruit 37 et deux voies comprenant chacune un mélangeur 33, 33', un filtre 32, 32', et un échantillonneur 34, 34'. Le mélangeur 33 est relié à un oscillateur local via un déphaseur de π/2 tandis que le mélangeur 33' est directement relié à cet oscillateur. Les sorties respectives des deux échantillonneurs 34, 34' sont traitées numériquement en bande de base 35. Dans ce type de dispositif, les opérations de filtrage de canal sont effectuées au niveau des filtres 32, 32' réalisés en technologie analogique dont les caractéristiques fixes conditionnent fortement les performances globales du récepteur et le niveau de protection contre les interférences.

Ce type de traitement présente ainsi des inconvénients en termes de précision, de dérive et d'adaptation à différents canaux et de débits de bits.

Le but de l'invention est de remédier à ces inconvénients en proposant un récepteur numérique à fréquence intermédiaire qui présente une meilleure précision, pas de dérive, et une adaptativité qui permette d'en ajuster les caractéristiques en fonction des besoins, par exemple pour s'adapter à différentes modulations ou largeurs de bande, éliminer un brouilleur, réaliser un préfiltrage ou un filtrage adaptatif pour l'égalisation.

Suivant l'invention, le récepteur comprenant des moyens d'antenne pour capter des signaux, des moyens pour convertir à une fréquence intermédiaire prédéterminée un signal d'entrée et des moyens de traitement en bande de base, est caractérisé en ce qu'il comprend en outre des moyens de conversion analogique/numérique avec suréchantillonnage par rapport à la largeur de bande du signal ramenant le signal en bande de base, qui reçoivent en entrée le signal reçu et converti à fréquence intermédiaire, et des moyens de filtrage à décimation recevant en entrée le signal converti et reliés en sortie aux moyens de traitement en bande de base.

Ainsi, dans un récepteur numérique selon l'invention, certaines fonctions de filtrage effectuées antérieurement sur des signaux analogiques sont reportées dans la partie numérique. Le bruit hors bande est éliminé par le filtre de décimation qui peut de plus assurer d'autres fonctions de filtrage. En outre, l'implantation de la conversion ainsi proposée devient aisée dans un circuit intégré. De plus, le récepteur selon l'invention offre une adaptativité de la largeur de bande du signal.

Selon un mode avantageux de réalisation d'un récepteur selon l'invention, ce récepteur comprend en outre, en sortie des moyens de conversion analogique/numérique avec suréchantillonnage, deux voies comprenant chacune des moyens de filtrage à décimation reliés aux moyens de traitement en bande de base.

Suivant un autre aspect de l'invention, il est proposé un procédé de filtrage numérique en bande de base d'un signal d'entrée préalablement converti à une fréquence intermédiaire prédéterminée, caractérisé en ce qu'il comprend une étape de conversion analogique/numérique avec une fréquence d'échantillonnage supérieure au double de la largeur de bande du signal d'entrée (suréchantillonnage) mais pouvant être inférieure au double de la fréquence intermédiaire (sous-échantillonnage) afin de ramener le signal en bande de base par repliement du spectre, suivie d'une étape de mise en forme dudit signal ainsi converti par filtrage de décimation.

D'autres particularités et avantages de l'invention apparaîtront encore dans la description ci-après. Aux dessins annexés donnés à titre d'exemples non limitatifs :

- la figure 1 est un schéma synoptique d'un récepteur conventionnel à deux voies selon l'art antérieur ;
- la figure 2 est un schéma synoptique d'un récepteur numérique selon l'invention ;
- La figure 3 est un schéma synoptique d'un convertisseur Sigma-Delta ;
- la figure 4 représente un exemple d'évolution de la densité spectrale de puissance en fonction de la fréquence, obtenu avec le procédé selon l'invention ; et
- la figure 5 représente la densité spectrale de puissance du bruit pour deux fréquences d'échantillonnage.

On va maintenant décrire une forme particulière de réalisation d'un récepteur numérique selon l'invention, en référence aux figures 2 à 5.

Un récepteur numérique 1 selon l'invention, comprend, à titre d'exemple non limitatif, en référence à la figure 2, une antenne de réception 11, un filtre passe-bande 16 suivi d'un préamplificateur à faible bruit 20 sur toute la bande de fréquence du récepteur, un mélangeur 21 suivi d'un filtre passe-bande 22 pour ramener le signal à une fréquence intermédiaire prédéterminée, un module de conversion analogique/numérique 15 générant un signal numérique sur 1 bit, suivi de deux canaux en quadrature 12, 13 comprenant chacun un filtre à décimation 9,10 délivrant une information numérique sur n bits et reliés à un module de traitement en bande de base 14.

Le module de conversion analogique/numérique 15 peut être avantageusement réalisé sous la forme d'un convertisseur dit Sigma-Delta comme l'enseigne l'ouvrage intitulé "Oversampling Delta-Sigma Data Converters" (convertisseurs de données Delta-Sigma à suréchantillonnage) IEEE Press, par James C.CANDY et Gabor C.TEMES. Les convertisseurs Sigma-Delta sont des convertisseurs analogique/numérique conçus pour être intégrés. A titre d'exemple, un convertisseur Sigma-Delta 15 comprend, en référence à la figure 3, un filtre 3, un échantillonneur 4, un quantificateur 5, par exemple un quantificateur de un bit, et une boucle 6 comprenant un convertisseur numérique/analogique éventuellement suivi d'un filtre analogique, et un soustracteur 2 recevant en entrée positive le signal à convertir et en entrée négative un signal de sortie du convertisseur numérique/analogique ou du filtre analogique si celui-ci est présent. Ce convertisseur 15 est généralement suivi d'un ou plusieurs filtres à décimation 16. La fréquence d'échantillonnage doit être proportionnelle à la fréquence intermédiaire afin de ramener en bande de base une composante du signal échantillonné par repliement de spectre. Le facteur de proportionnalité entre les deux fréquences doit être du type:

$$f_{\text{échantillonnage}} = \frac{4}{2m + 1} \cdot f_{FI}$$

avec $f_{FI}$: fréquence intermédiaire

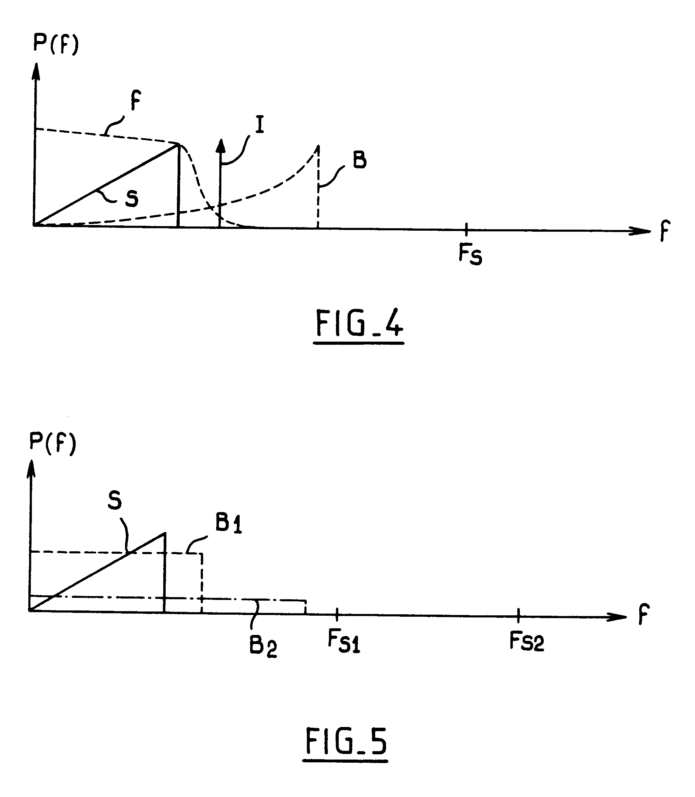

et m: entier positif ou nul prédéterminé, afin de bien ramener une composante du signal en bande de base comme décrit dans l'article "Interpolative bandpass A/D Conversion" (conversion A/N passe-bande interpolatrice) de Hans-Joachim DRESLER, Signal Processing 22 (1991) 139-151. La fréquence intermédiaire $f_{FI}$ et le coefficient m doivent de plus être choisis tels que la fréquence d'échantillonnage soit supérieure au double de la largeur de bande du signal entrant (fréquence de Nyquist), mais en pratique on observe des rapports beaucoup plus élevés, par exemple de 20 à 100. Ceci est du au fait que le quantificateur contribue à ajouter au signal un bruit de quantification élevé, surtout lorsqu'il s'agit d'un quantificateur à un bit qui n'est qu'un simple comparateur, et il est alors recommandé d'augmenter la fréquence d'échantillonnage afin de diminuer le niveau de bruit de quantification dans la bande utile du signal. En effet, si on suppose que le bruit de quantification peut être assimilé à un bruit blanc, la densité spectrale de puissance apportée par le quantificateur 5 présente une évolution fréquentielle telle que représentée en figure 5 où S représente la densité spectrale du signal tandis que B1 représente la densité spectrale du bruit blanc, pour une fréquence d'échantillonnage Fs1. Si on choisit une fréquence d'échantillonnage Fs2 nettement plus élevée que la fréquence de Nyquist, alors la densité spectrale de bruit B2 est dispersée sur une plus large bande, en référence à la figure 5, et le signal utile S est moins affecté.

La boucle de contre-réaction 6 contribue à rejeter le bruit en dehors de la bande de signal à l'aide d'un filtre 3 judicieusement placé avant l'échantillonneur 4 commandé en suréchantillonnage. On obtient avec ce type de conversion des densités spectrales de puissance en bande de base telles que représentées en figure 4, où la densité spectrale de bruit B reste minime dans la bande de signal et ne croît qu'au delà de cette bande jusqu'à la fréquence Fs/2. Il est alors nécessaire pour des raisons pratiques de réduire la fréquence d'échantillonnage au niveau de la fréquence de Nyquist, ou légèrement au dessus. Ceci peut être réalisé numériquement au moyen d'un filtre à décimation qui a pour fonction de rejeter le bruit hors-bande, les éventuelles réplications du spectre dues au repliement de spectre et d'éventuels brouilleurs se manifestant par des fréquences supérieures à celles du signal utile et inférieures à la fréquence de Nyquist, et de couper la fréquence d'échantillonnage. Le choix de la fréquence de coupure de ce filtre est le résultat d'un compromis dans la mesure où une trop grande fréquence de coupure conduit à une protection insuffisante contre les interférences et une trop faible conduit à une distorsion du signal. Le principe de décimation mis en oeuvre dans ce type de filtre et des modes de synthèse sont notamment décrits dans l'article "Interpolation and Decimation of Digital Signals"(Interpolation et décimation de signaux numériques) de R.E. CROCHIERE et L.R. RABINER, Proceedings of the IEEE, Vol.69, No.3, Mars 1981.

Dans le cas du récepteur numérique selon l'invention représenté en figure 2, le convertisseur analogique/numérique 15 est appliqué à un signal en fréquence intermédiaire IF préalablement soumis à un filtrage passe-bande 22. Il est particulièrement avantageux de mettre en oeuvre une technique dite de "sous-échantillonnage" consistant à choisir pour la fréquence d'échantillonnage, non pas une fréquence au moins deux fois supérieure à la fréquence maximale du signal (fréquence de Nyquist), mais une fréquence au moins deux fois supérieure à la largeur de bande utile du signal, ce qui revient dans le cas d'un signal à fréquence intermédiaire à diminuer considérablement la fréquence d'échantillonnage et donc à améliorer les performances du récepteur numérique. Le principe du sous-échantillonnage mis en oeuvre au niveau de l'échantillonneur 4, qui est notamment décrit dans l'article "Undersampling techniques simplify digital radio" (les techniques de sous-échantillonnage simplifient la radio numérique) de Richard GROSHONG et Stephen RUSCAK, paru dans la revue "Electronic Design" du 23 Mai 1991, permet de ramener le signal de fréquence intermédiaire en bande de base.

On va maintenant décrire les effets obtenus sur les spectres de puissance par mise en oeuvre du procédé selon l'invention. En référence à la figure 4 qui représente la densité de puissance spectrale P(f) d'un signal reçu S, on observe une fréquence d'interférence I, un spectre de bruit de quantification B pour une fréquence d'échantillonnage Fs et un filtre F.

Il faut noter que le bruit de quantification est pratiquement rejeté de la bande utile et qu'il peut être supprimé par les filtres à décimation 9, 10 qui contribuent également à la suppression de la fréquence d'interférence I. En pratique, les filtres à décimation peuvent être très longs.

Dans un mode effectif de réalisation de l'invention, pour une fréquence de sortie du quantificateur à un bit égale à 200 kHz, le filtre décimateur délivre des informations sur 8 bits à une fréquence de 8 kHz, ce qui correspond à un débit numérique de 64 kbits/seconde.

En outre, avec l'invention, le caractère numérique du filtre offre la possibilité d'une très grande adaptativité et on peut alors accorder les caractéristiques du récepteur en cours de communication et résoudre le problèmes des taux de bits adaptatifs.

Bien sûr, l'invention n'est pas limitée aux exemples qui viennent d'être décrits et de nombreux aménagements peuvent être apportés à ces exemples sans sortir du cadre de l'invention. Ainsi, le procédé selon l'application peut apporter une solution satisfaisante pour des largeurs de bande variables et des débits de bit adaptatifs dans de futures applications, telles que RACE ou UMTS.

## Revendications

1. Récepteur numérique (1) comprenant des moyens de conversion analogique (21) pour convertir un signal entrant à une fréquence intermédiaire prédéterminée (IF) et des moyens de traitement en bande de base (14), caractérisé en ce qu'il comprend en outre des moyens de conversion analogique/numérique (15) qui reçoivent en entrée le signal à fréquence intermédiaire pour le traiter avec suréchantillonnage par rapport à la largeur de bande du signal en bande de base et avec sous-échantillonnage par rapport à ladite fréquence intermédiaire, et des moyens de filtrage à décimation (9, 10) recevant en entrée le signal converti issu desdits moyens de conversion analogique/numérique (15) et reliés en sortie auxdits moyens de traitement en bande de base (14).

2. Récepteur (1) selon la revendication 1, caractérisé en ce qu'il comprend en outre, en aval des moyens de conversion analogique/numérique avec suréchantillonnage (15), deux voies (12, 13) comprenant chacune des moyens de filtrage à décimation (9, 10) dont les sorties respectives sont reliées aux moyens de traitement en bande de base (14).

3. Récepteur (1) selon l'une des revendications 1 ou 2, caractérisé en ce que les moyens de conversion analogique/numérique sont de type Sigma-Delta et comprennent des moyens soustracteurs (2), des moyens de filtrage (3), des moyens d'échantillonnage (4), des moyens de quantification (5), et au sein d'une boucle de retour (6), des moyens de conversion numérique/analogique.

4. Récepteur (1) selon la revendication 3, caractérisé en ce que les moyens de quantification (5) génèrent des informations de sortie sur un bit.

5. Récepteur (1) selon l'une des revendications 3 ou 4, caractérisé en ce que la boucle de retour (6) comprend en outre, en aval desdits moyens de conversion numérique/analogique, des moyens de filtrage analogique.

6. Récepteur (1) selon l'une quelconque des revendications 1 à 5, caractérisé en ce que les moyens de conversion analogique/numérique et/ou les moyens de filtrage à décimation sont réalisés sous forme de circuit intégré.

7. Procédé de filtrage numérique en bande de base d'un signal d'entrée préalablement converti à une fréquence intermédiaire prédéterminée, mis en oeuvre dans un récepteur selon l'une quelconque des revendications 1 à 6, caractérisé en ce qu'il comprend une étape de conversion analogique/numérique avec une fréquence d'échantillonnage supérieure au double de la largeur de bande du signal d'entrée (suréchantillonnage) mais pouvant être inférieure au double de la fréquence intermédiaire (sous-échantillonnage) afin de ramener le signal en bande de base par repliement du spectre, suivie d'une étape de mise en forme dudit signal ainsi converti par filtrage de décimation.

8. Procédé selon la revendication 7, caractérisé en ce que la séquence de conversion analogique/numérique avec suréchantillonnage comprend une étape de soustraction au signal reçu d'un signal obtenu par conversion numérique/analogique et éventuellement filtrage du signal issu de ladite séquence de conversion analogique/numérique avec suréchantillonnage pour fournir un signal de différence qui est ensuite soumis successivement à une étape de filtrage, une étape d'échantillonnage et une étape de quantification pour délivrer un signal numérique converti.

9. Procédé selon l'une des revendications 7 ou 8, mis en oeuvre dans un récepteur numérique comprenant deux voies, caractérisé en ce que la séquence de filtrage à décimation comprend deux séquences parallèles de filtrage à décimation appliquées respectivement à deux voies (12, 13).

10. Procédé selon l'une quelconque des revendications 7 à 9, caractérisé en ce que le filtrage à décimation est de type adaptatif.

FIG_1

FIG_2

FIG_3

## FIG.4

## FIG.5

Office européen
des brevets

**RAPPORT DE RECHERCHE EUROPEENNE**

Numero de la demande

EP 94 40 0564

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| X | GLOBECOM '92 CONFERENCE RECORD, vol.1, 6 Décembre 1992, ORLANDO,FL,US pages 457 - 461, XP357829 PARK ET AL 'A Digital Am Radio With CQUAM Stereo' * page 459; figures 4,5 * | 1,2,6,7,9 | H04B1/30 H03D3/00 |
| A |   --- | 3-5,8,10 | |
| A | WO-A-87 01531 (MOTOROLA) * abrégé; figures 1-3,5 * * page 4, ligne 6 - page 5, ligne 18 *   ----- | 1-10 | |
| | | | **DOMAINES TECHNIQUES RECHERCHES (Int.Cl.5)** |
| | | | H04B H03D |

Le présent rapport a été établi pour toutes les revendications

| Lieu de la recherche | Date d'achèvement de la recherche | Examinateur |
|---|---|---|
| LA HAYE | 13 Juin 1994 | Andersen, J.G. |

EPO FORM 1503 03.82 (P04C02)